(19) Europäisches Patentamt
European Patent Office
Office européen des brevets

(11) EP 3 276 339 A1

(12) EUROPEAN PATENT APPLICATION

(43) Date of publication:
31.01.2018 Bulletin 2018/05

(51) Int Cl.:
G01N 27/20 (2006.01)      G01N 27/24 (2006.01)
G01N 33/44 (2006.01)

(21) Application number: 17180473.5

(22) Date of filing: 10.07.2017

(84) Designated Contracting States:
AL AT BE BG CH CY CZ DE DK EE ES FI FR GB
GR HR HU IE IS IT LI LT LU LV MC MK MT NL NO
PL PT RO RS SE SI SK SM TR
Designated Extension States:
BA ME
Designated Validation States:
MA MD

(30) Priority: 27.07.2016 GB 201612981

(71) Applicant: Rolls-Royce plc
London SW1E 6AT (GB)

(72) Inventor: Lambourne, Alexis
Derby, Derbyshire DE24 8BJ (GB)

(74) Representative: Rolls-Royce plc
Intellectual Property Dept SinA-48
PO Box 31
Derby DE24 8BJ (GB)

(54) **ELECTRICAL INSPECTION METHOD FOR FIBRE COMPOSITE MATERIALS**

(57) A method of determining the position of a defect (32) within a fibre composite article (10) comprising a plurality of electrically conductive fibres (14) embedded within a non-conductive matrix (15). The method comprises providing an array of spaced electrical contacts (12a-k) in electrical contact with fibres (14) of the article (10); conducting an electrical current between two or more spaced electrical contacts (12a-k) of the array to determine a measured electrical profile of the article comprising measurements of at least one of electrical resistance, inductance, capacitance and self-resonant frequency of the article; and comparing the electrical profile with a nominal electrical profile representative of an undamaged article to determine the presence of a defect within the article.

FIG. 5

## Description

The present disclosure concerns a fibre composite material inspection method.

Fibre composite materials such as carbon fibre reinforced plastic (CFRP) comprise a plurality of fibres embedded within a matrix. In the case of CFRP, the fibres comprise carbon fibre, while the matrix comprises a curable resin. The composite has bulk material properties such as strength which exceeds that of its components.

Such materials have greater strength to weight ratios than many traditional aerospace materials such as aluminium. Furthermore, composite materials are less susceptible to corrosion. However, damage to fibre composite components may still occur.

Several methods have been proposed for detecting defects in fibre composite materials. These include X-ray and ultrasound scanning and Magnetic Resonance Imaging (MRI). However, these techniques frequently require direct line of sight of the component, which makes inspection difficult without removing the component from larger subassemblies. Furthermore, X-ray, ultrasound and MRI equipment tend to be relatively bulky, which makes onsite inspection impractical. It is also known to provide on-board sensors such as laser diffraction sensors, which detect strain in use. However, such methods are heavy and expensive, and only detect strains rather than actual damage. Similarly, where the composite part comprises a plurality of layers of material, defects may be hidden beneath the surface, making visual inspection inadequate.

Consequently, the present invention seeks to provide a method of detecting a defect in a fibre composite material that seeks to overcome the above problems.

According to a first aspect of the invention there is provided a method of determining the position of a defect within a fibre composite article comprising a plurality of electrically conductive fibres embedded within a non-conductive matrix, the method comprising:

providing an array of spaced electrical contacts in electrical contact with fibres of the article;
conducting an electrical current between two or more spaced electrical contacts of the array to determine a measured electrical profile of the article comprising measurements of at least one of electrical resistance, inductance, capacitance and self-resonant frequency of the article; and
comparing the electrical profile with a nominal electrical profile representative of an undamaged article to determine the presence of a defect within the article.

Advantageously, from a comparison of a measured electrical profile to a nominal profile of an undamaged part, damage can be readily detected. The method is highly repeatable, and so do not require direct line of access to the part, while being relatively inexpensive.

The conductive fibres may comprise non-metallic fibres, such as carbon fibre, and the non-conductive matrix may comprise a polymer such as a thermoset resin such as any of epoxy, phenolic, polyester resin, vinyl ester resin and urethane.

The fibre composite article may comprise a plurality of layers of fibres. Each layer of fibres may comprise a plurality of woven fibres.

The array of electrical contacts may comprise a solder contact which may comprise a low temperature solder such as one or more of C-Solder™ a tin, lead, bismuth, antimony, silver, indium, zinc or copper based solder . The solder contact may comprise solder bonded to the electrically conductive fibres.

The method may comprise drilling a hole through a plurality of layers of fibres and applying a molten solder into the hole. Advantageously, each contact is electrically connected to multiple plies (layers) of carbon fibre, which may have different orientations.

The array of electrical contacts may comprise at least first and second contacts electrically connected to separate fibre layers, which may be spaced from one another within the plane of each fibre layer.

The step of determining an electrical profile may comprise providing a further electrical connection between the first and second contacts, and determining one of a resistance, a capacitance and an inductance between the first and second contacts.

The method may comprise determining a first electrical path within the composite material between the first and second electrical contacts, and determining the presence of a defect along the electrical path where the determined electrical profile of the first and second contacts differs from the nominal electrical profile.

The method may comprise providing at least third and fourth electrical contacts spaced from the first and second contacts which define a second electrical path through the composite component that intersects the first electrical path.

The method may comprise determining the presence of a defect at the point of intersection of the first and second paths where the determined electrical profile of the first and second contacts and the third and fourth contacts both differ from the nominal electrical profile. Step change differences in point-to-point electrical properties over time indicate the presence of damage or defects.

The electrical current may comprise one of a DC electrical current and an AC electrical current. Where a DC current is used, electrical resistance can be reliably measured to determine bulk material properties. On the other hand, where an AC current is used, one or both of inductance and capacitance can be determined, to determine one or more of the parallel resonance (of inductance and capacitance), the impedance, the resonance and the admittance.

The skilled person will appreciate that except where mutually exclusive, a feature described in relation to any one of the above aspects may be applied mutatis mutandis to any other aspect. Furthermore except where mutually exclusive any feature described herein may be applied to any aspect and/or combined with any other feature described herein.

An embodiment will now be described by way of example only, with reference to the Figures, in which:

Figure 1 is a plan view of a composite component comprising a defect detection apparatus;

Figure 2 is a cross sectional view of the component of figure 1 through the through the line A-A of figure 1;

Figure 3 is a plan view of the composite component of figure 1 illustrating a plurality of electrical paths between an array of contact points;

Figures 4 is a plan view of the composite component of figure 1 having a defect;

Figure 5 is a cross-sectional view of the composite component of figure 1 along the line A-A in figure 1; and

Figures 6a-c show cross-sectional of the composite component of figure 1 at first, second and third steps of an electrical contact forming process; and

Figure 7 is a process flow diagram illustrating a method of detecting a defect in a composite component.

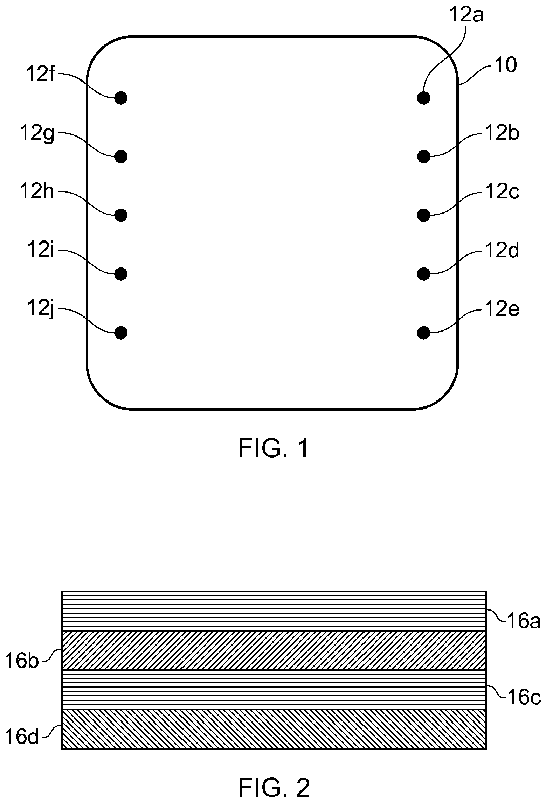

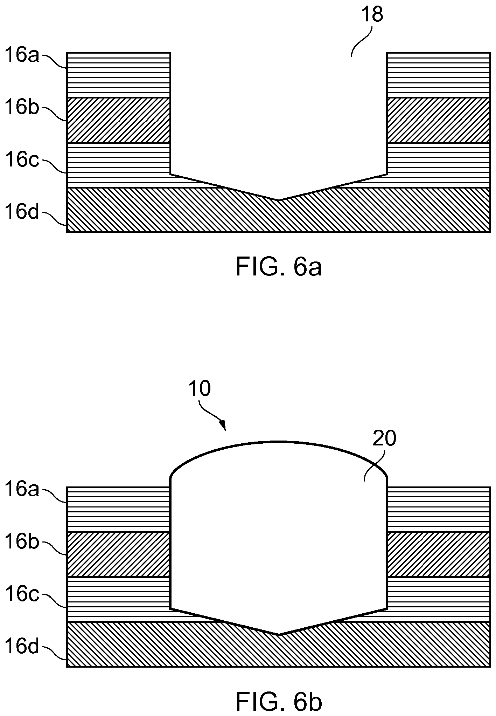

With reference to the figures, there is provided a method of detecting a defect in a composite article 10 shown in figures 1 to 5, the method being outlined in figure 6.

Referring to figures 1 and 2, the article 10 comprises a composite material comprising a plurality of electrically conductive, non-metallic fibres such as carbon fibres 14, embedded within a matrix 15 comprising a polymer thermoplastic such as epoxy. The carbon fibres 14 are arranged in a plurality of generally planar layers 16a, 16b. The fibres in each layer 16a, 16a are arranged such that the fibres 14 have a long axis aligned with the plane of the respective layer 16a-d. Fibres within adjacent layers 16a, 16b are generally oriented at an angle to one another, such as 90 and 45 degrees, though other relative orientations can be provided for. In some cases, fibres within a layer may be woven, with approximately half of the fibres being oriented in a first direction parallel to the plane of the layer 16a, 16b, with the remaining fibres being aligned to the plane of the layer 16a, 16b, and normally to the other half of the fibres 14. In such a case, the fibres in adjacent layers are arranged approximately 45 degrees relative to each other. Consequently, the strength of the bulk material in directions parallel to the planes of the layers 16 is improved. The carbon fibres may be in the form of carbon nanotubes such as multi-walled carbon nanotubes (MWNT).

The article 10 comprises an array of spaced electrical contacts 12a-k. The electrical contacts 12 are provided in electrical contact with the electrically conductive fibres 14 of the composite article 10 within the plane of layers 16, and are generally provided in electrical contact with a plurality of layers, as described below.

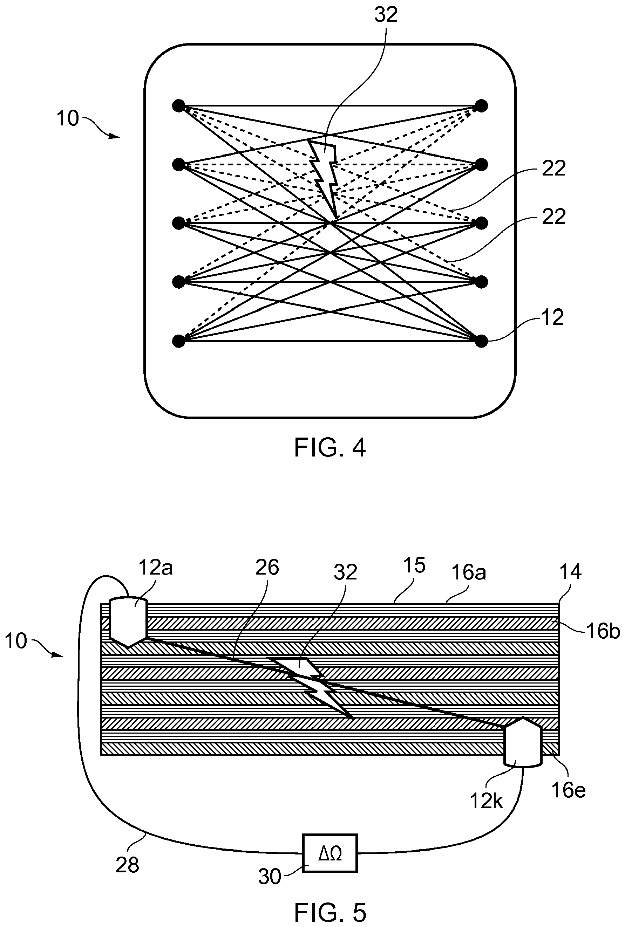

Figures 6a and 6b show the contacts 12 in more detail, and illustrate a method of bonding the contacts 12 to the fibres 14 to ensure a consistent electrical contact. In a first step, shown in figure 5a, a hole 18 is drilled into the article 10, in a direction generally normal to the plane of the layers 16, and to a depth extending through several layers 16a-d.

In a second step, a quantity of solder 20 is introduced into the hole 18 in a molten phase. The solder 20 is of a type that provides a consistent electrical contact with the fibres 14 of the article 10. The calculated surface free energy of multi walled carbon nanotubes is around 20 - 50mJ m$^{-2}$, meaning that only liquid metals with a low surface tension of around 100-200mN m$^{-1}$ will wet the surface of carbon nanotubes and carbon fibres. The inventors have found that a tin-based solder compound sold commercially as C-Solder™ is particularly suitable, in view of the strong mechanical bond provided between the solder 20 and the fibres 14, and the consistent electrical contact that is provide by such a bond. This process is repeated for each contact 12. However, it will be understood that other metallic, low temperature solders may be suitable, such as any of tin, lead, bismuth, antimony, silver, indium, zinc or copper based solder. In multi-layer carbon fibre composite materials, electrical conductivity is highest in the fibre direction (X), somewhat lower in the transverse direction (Y), and is very low in the stacking direction (Z), i.e. there is little conduction between plies. Thus to detect a fault or defect it is preferable to penetrate at least two and ideally four plies to get a good averaged conductivity over a range of plies and orientations without having to rely on poor and random connections in the Z direction.

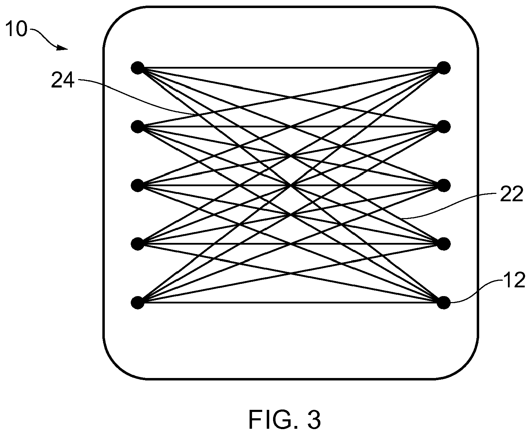

Referring now to figure 3, a plurality of intra-plane electrically conductive paths 22 are defined between each spaced pair of electrical contacts 12a-j. The electrically conductive paths 22 extend along the plane of the first layer 16a. In view of the separation of the contacts 12a-j within the plane of the first layer 16a, a plurality of the paths 22 intersect with one another at a plurality of intersection points 24. Consequently, an array of intersection points 24 is defined.

Referring to figure 5, one or more further electrical contacts 12k may be provided, which are in electrical contact with one or more layers 16e spaced from the first layer 16a. Consequently, a further inter-plane electrical path 26 is defined extending between a first contact 12a provided in electrical contact with electrically conductive fibres 14 of the first layer 16a, and a further contact provided in electrical contact with electrically conductive fibres 14 of the further layer 16e.

As shown in figure 5, a further electrical connection 28 is provided between the contacts 12a, 12k. Consequently, an electrical circuit is defined by the contacts 12a, 12k, path 26 and connection 28. An LCR meter 30, (a type of electronic test equipment used to measure the inductance (L), capacitance (C), and resistance (R) of an electronic component) is provided, to determine one or more of an electrical inductance, capacitance and resistance of the electrical circuit. The LCR meter 30 is provided within the electrical circuit, in electrical contact with the connection 28. The LCR meter 30 may comprise a power source such as a battery, transformer or variable frequency supply configured to provide both AC and DC electrical current through the electrical circuit, and sensors configured to measure each of inductance, capacitance, resistance and voltage and current at the LCR meter 30. The LCR meter 30 can be used to provide a range of AC frequencies to determine the mutual coupling and harmonic behaviour of the inductance and capacitance of the electrical paths 34, 36. Harmonics will provide a unique electrical identification for the condition of the article.

At some frequency, the circuit achieves the "self-resonant frequency" or SRF, where the capacitance (C) forms a parallel resonance with the inductance (L) and the inductor becomes a tuned circuit. At frequencies below the Self-Resonate Frequency, the model appears to be inductive; at frequencies above the SRF it appears to be capacitive and at the SRF it is resistive, as the inductive and capacitive reactance are equal in magnitude but opposite in sign and thus cancel each other out.

At the SRF of an inductor, all of the following conditions are met:

- the input impedance is at its peak;
- the phase angle of the input impedance is zero, crossing from positive (inductive) to negative (capacitive);
- the effective inductance is zero, since the negative capacitive reactance ($X_C=1/2\pi fC$) cancels the positive inductive reactance ($X_L= 1/2\pi fL$), where $X_L$ is positive inductive reactance (ohms), f is frequency (Hertz), L is inductance (Henrys), $X_C$ is capacitive reactance (ohms), and C is capacitance (Farads).

The following equation shows how the SRF is related to inductance and capacitance in the inductor model circuit.

$$F_{SR} = \frac{1}{\left( 2\pi \sqrt{\left( LC_p \right)} \right)}$$

where :

$F_{SR}$ is the Self-Resonant Frequency (in Hz);
L is the inductance in Henrys; and
$C_p$ is the parasitic capacitance in Farads.

From this equation, it is clear that increasing inductance or capacitance lowers the measured SRF. Reducing inductance or capacitance raises the SRF. Since the capacitance depends on the spatial separation between conductors, if the structure is damaged, the capacitance and hence the SRF will also change. If fibres are damaged or broken, then the inductance changes and hence the SRF will also change. Both of these alter the electrical profile of the material indicating damage.

Further electrical connections (not shown) are provided between each pair of electrical contacts 12a-j. It will be understood that the electrical contacts do not have to be provided simultaneously, and can be made for the purpose of determining the electrical profile as described below, then broken for determining further electrical profiles. Again, in each case, the LCR meter 30 is provided in electrical series with the circuit defined by the electrical contact pairs, electrical paths 22, and electrical connection, and can be used to determine one or more of a resistance, inductance and capacitance in the respective electrical circuit.

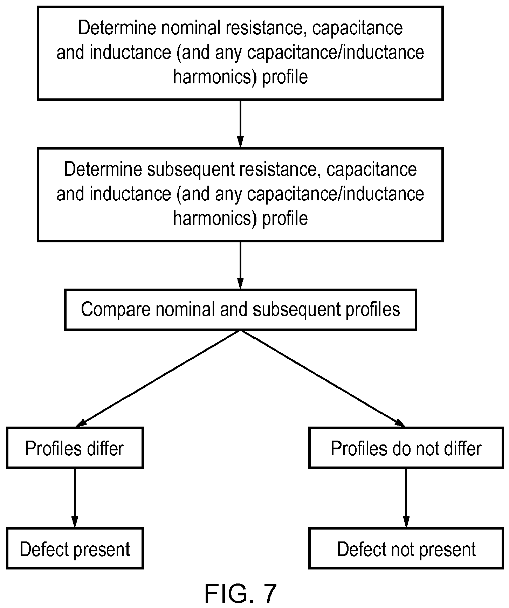

Referring now to figures 4, 5 and 7, a method of determining a defect in the article 10 is as follows.

In a first step, a nominal electrical profile of the undamaged article 10 is made. This includes electrical resistance (DC) and inductance and capacitance (AC) and resonances in the inductance and capacitance (Variable frequency AC). The nominal electrical profile comprises an array of measurements of the electrical properties of each electrical path 22, 26 of the undamaged article. The LCR meter 30 is electrically coupled to each circuit via the respective connection 28, to thereby determine the electrical properties of each path 22, 26 between each contact pair 12.

In a second step, after a period of time in service, a subsequent electrical profile is determined by repeating the above first step, and recording the measured values.

In a third step, the electrical profiles of the nominal (start of life) and service-run components are compared. If an element in the array differs, i.e. if the electrical properties along a path 22, 26 of the subsequent profile is different to the electrical properties along a path 22, 26 of the nominal profile, then a defect is determined to be present.

For example, a change of resistance from the nominal to the measured profile indicates a change in the bulk material properties such as one or more broken fibres 14, and can be measured with the application of a DC voltage. On the other hand, applying an AC voltage along the paths 22, 26 allows measurements of inductance and capacitance to be made. Applying a variable frequency of AC voltage to the article allows resonances (points in the AC frequency spectrum where the inductance and capacitance cancel each other out) to be identified. These resonances are fundamental properties of the article and will alter if the article is damaged or degraded. Since the capacitance depends on the spatial separation between conductors if the structure is damaged, the capacitance and hence the SRF will also change. If fibres are damaged or broken, then the inductance changes hence the SRF will also change. Both of these alter the electrical profile of the material indicating damage.

Figure 4 illustrates how the position of a defect can be determined using the method of the present disclosure. In figure 4a, a defect 32 is located at the position shown. By performing the above first through third steps, it is determined that the subsequent electrical profiles of the paths 22 shown as dotted lines differ to the nominal profile, while the subsequent electrical profiles of the paths 22 shown as solid lines have the same electrical property values (i.e. each of resistance, inductance and capacitance) as the nominal resistance profile. Consequently, it will be understood that the defect 32 can be determined to lie within the shaded region by knowledge of the positions of the contacts 12, and the subsequent resistance profile.

Similarly, figure 5 illustrates how a defect may be determined to lie underneath the surface layer 16a. Since the defect lies within the path 26, the electrical properties of a subsequent resistance profile in this case will differ from that of the nominal profile, and so a defect can be deduced to be present along this line. The spatial resolution of the method can be increased by introducing further contacts 12.

It will be understood that the invention is not limited to the embodiment above-described and various modifications and improvements can be made without departing from the concepts described herein. Except where mutually exclusive, any of the features may be employed separately or in combination with any other features and the disclosure extends to and includes all combinations and subcombinations of one or more features described herein.

## Claims

1. A method of determining the position of a defect within a fibre composite article comprising a plurality of electrically conductive fibres embedded within a non-conductive matrix, the method comprising:

    providing an array of spaced electrical contacts in electrical contact with fibres of the article;
    conducting an electrical current between two or more spaced electrical contacts of the array to determine a measured electrical profile of the article comprising measurements of at least one of electrical resistance, inductance, capacitance and self-resonant frequency of the article; and

    comparing the electrical profile with a nominal electrical profile representative of an undamaged article to determine the presence of a defect within the article.

2. A method according to claim 1, wherein the conductive fibres comprise carbon fibre.

3. A method according to claim 1 or claim 2, wherein the non-conductive matrix comprises a polymer such as a thermoset resin.

4. A method according to claim 2, wherein the non-conductive matric comprises one or more of epoxy, phenolic, polyester resin, vinyl ester resin and urethane.

5. A method according to any of the preceding claims, wherein the fibre composite article comprises a plurality of layers of fibres.

6. A method according to any of the preceding claims, wherein the array of electrical contacts comprises a solder contact.

7. A method according to claim 6, wherein the solder comprises one or more of C-Solder™, a tin, lead, bismuth, antimony, silver, indium, zinc or copper based solder.

8. A method according to claim 6 or claim 7, wherein the method comprises drilling a hole through a plurality of layers of fibres and applying a molten solder into the hole.

9. A method according to any of the preceding claims, wherein the array of electrical contacts comprises at least first and second contacts electrically connected to separate fibre layers.

10. A method according to claim 9, wherein the first and second contacts are spaced from one another within the plane of each fibre layer.

11. A method according to any of the preceding claims, wherein the step of determining an electrical profile comprises providing a further electrical connection between the first and second contacts, and determining one of a resistance, a capacitance and an inductance between the first and second contacts.

12. A method according to claim 11, wherein the method comprises determining a first electrical path within the composite material between the first and second electrical contacts, and determining the presence of a defect along the electrical path where the determined electrical profile of the first and second contacts differs from the nominal electrical profile.

**13.** A method according to claim 12, wherein the method comprises providing at least third and fourth electrical contacts spaced from the first and second contacts which define a second electrical path through the composite component that intersects the first electrical path.

**14.** A method according to claim 13, wherein the method comprises determining the presence of a defect at the point of intersection of the first and second paths where the determined electrical profile of the first and second contacts and the third and fourth contacts both differ from the nominal electrical profile.

FIG. 1

FIG. 2

FIG. 3

FIG. 4

FIG. 5

16a

16b

16c

16d

18

FIG. 6a

10

20

16a

16b

16c

16d

FIG. 6b

FIG. 7

Europäisches
Patentamt

European
Patent Office

Office européen
des brevets

# EUROPEAN SEARCH REPORT

Application Number

EP 17 18 0473

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | JP H05 269874 A (NAKAMURA, SATOSHI) 19 October 1993 (1993-10-19) <br> * figures 1, 2, 3 * <br> * paragraph [0006] - paragraph [0012] * <br> * paragraph [0014] - paragraph [0034] * <br> ----- | 1-3,5, 9-14 | INV. <br> G01N27/20 <br> G01N27/24 <br> G01N33/44 |
| X | GB 2 421 952 A (UNIV SHEFFIELD [GB]) 12 July 2006 (2006-07-12) <br> * figures 1, 2, 3 * <br> * page 3, line 19 - page 4, line 9 * <br> * page 7, line 23 - page 9, line 15 * <br> * page 11, line 25 - page 13, line 24 * <br> * page 15, line 8 - line 20 * <br> ----- | 1-5,9-14 | |
| X | WO 2011/049801 A1 (APPLIED NANOSTRUCTURED SOLS [US]; MALECKI HARRY C [US]; HUGHES JOHN AN) 28 April 2011 (2011-04-28) <br> * figures 1, 2, 3, 4, 5, 6 , 7, 8, 9, 10, 12, 14 * <br> * paragraph [0038] - paragraph [0039] * <br> * paragraph [0042] - paragraph [0045] * <br> * paragraph [0064] - paragraph [0090] * <br> ----- | 1-14 | |
| A | LOU L AND HAYES S A: "A RESISTANCE-BASED DAMAGE LOCATION SENSOR FOR CARBON-FIBRE COMPOSITES", SMART MATERIALS AND STRUCTURES, IOP PUBLISHING LTD., BRISTOL, GB, vol. 11, 4 November 2002 (2002-11-04), pages 966-969, XP002373349, ISSN: 0964-1726, DOI: 10.1088/0964-1726/11/6/401 <br> * figures 1, 2, 3, 4, 5 * <br> * Section: "2. Experimental procedure"; page 967, column 2, paragraph 2 - page 968, column 1, paragraph 2 * <br> * Section: "3. Results"; page 968, column 1, paragraph 3 - page 969, column 1, paragraph 1 * <br> ----- | 1-3,5, 9-14 | TECHNICAL FIELDS SEARCHED (IPC) <br><br> G01N |

The present search report has been drawn up for all claims

| Place of search | Date of completion of the search | Examiner |
|---|---|---|
| Munich | 31 August 2017 | Melzer, Katharina |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

...........................................................................................

& : member of the same patent family, corresponding document

## ANNEX TO THE EUROPEAN SEARCH REPORT
## ON EUROPEAN PATENT APPLICATION NO.

EP 17 18 0473

This annex lists the patent family members relating to the patent documents cited in the above-mentioned European search report.
The members are as contained in the European Patent Office EDP file on
The European Patent Office is in no way liable for these particulars which are merely given for the purpose of information.

31-08-2017

| Patent document cited in search report | | Publication date | Patent family member(s) | | Publication date |
|---|---|---|---|---|---|
| JP H05269874 | A | 19-10-1993 | JP | H05269874 A | 19-10-1993 |
| | | | JP | H07102621 B2 | 08-11-1995 |
| GB 2421952 | A | 12-07-2006 | CA | 2586451 A1 | 13-07-2006 |
| | | | EP | 1834173 A1 | 19-09-2007 |
| | | | GB | 2421952 A | 12-07-2006 |
| | | | US | 2009294022 A1 | 03-12-2009 |
| | | | WO | 2006072767 A1 | 13-07-2006 |
| WO 2011049801 | A1 | 28-04-2011 | AU | 2010308373 A1 | 15-03-2012 |
| | | | CA | 2772425 A1 | 28-04-2011 |
| | | | CN | 102753961 A | 24-10-2012 |
| | | | EP | 2491376 A1 | 29-08-2012 |
| | | | JP | 2013508722 A | 07-03-2013 |
| | | | KR | 20130004559 A | 11-01-2013 |
| | | | US | 2011089958 A1 | 21-04-2011 |
| | | | WO | 2011049801 A1 | 28-04-2011 |
| | | | ZA | 201201370 B | 28-11-2012 |

EPO FORM P0459

For more details about this annex : see Official Journal of the European Patent Office, No. 12/82